# FASCICULE DE BREVET EUROPEEN

(11) **EP 1 756 886 B1**
(45) Date de publication et mention de la délivrance du brevet: **27.02.2013**
(21) Numéro de dépôt: 05753979.3
(22) Date de dépôt: 31.05.2005
(51) Int. Cl.: H01L 51/50, H01L 51/52

(54) **DIODE ORGANIQUE ELECTROLUMINESCENTE COMPRENANT UNE COUCHE ORGANIQUE DOPEE**
ORGANISCHE LEUCHTDIODE MIT DOTIERTER ORGANISCHER SCHICHT
ORGANIC LIGHT-EMITTING DIODE COMPRISING A DOPED ORGANIC LAYER

(30) Priorité: 02.06.2004 FR 0451091
(43) Date de publication de la demande: 28.02.2007
(73) Titulaire: Thomson Licensing, 92130 Issy-les-Moulineaux (FR)
(72) Inventeur: HAAS, Gunther, F-35760 Saint Grégoire (FR); CINA, Salvatore, F-38000 Grenoble (FR)
(74) Mandataire: Browaeys, Jean-Philippe
(86) Numéro de dépôt international: PCT/EP2005/052485
(87) Numéro de publication internationale: WO 2005/119807

(56) Documents cités:
- EP-A1- 0 996 176
- EP-A2- 1 394 870
- WO-A-03/107452
- WO-A1-2004/023574
- JP-A- 2001 023 775
- US-A1- 2004 095 064
- US-A1- 2004 115 859
- ZHOU X ET AL: "Low-voltage inverted transparent vacuum deposited organic light-emitting diodes using electrical doping" APPLIED PHYSICS LETTERS, AIP, AMERICAN INSTITUTE OF PHYSICS, MELVILLE, NY, US, vol. 81, no. 5, 29 juillet 2002 (2002-07-29), pages 922-924, XP012033136 ISSN: 0003-6951
- PFEIFFER M ET AL: "A LOW DRIVE VOLTAGE, TRANSPARENT, METAL-FREE N-I-P ELECTROPHORESCENT LIGHT EMITTING DIODE" ORGANIC ELECTRONICS, ELSEVIER, AMSTERDAM, NL, vol. 4, no. 1, juin 2003 (2003-06), pages 21-26, XP001161528 ISSN: 1566-1199

## Description

L'invention concerne les diodes organiques électroluminescentes (OLED) à émission dite « vers le haut » qui comprennent, entre l'une au moins des électrodes et la couche organique électroluminescente disposées entre ces électrodes, une couche organique dopée.

Dans les diodes dites « à émission vers le haut », la lumière émise par la couche électroluminescente sort de la diode du côté opposé au substrat ; le substrat n'est généralement pas transparent.

L'art antérieur décrit abondamment des structures de diodes organiques électroluminescentes comprenant, entre cathode et anode, dans l'ordre, une couche d'injection d'électrons, une couche de transport d'électrons, la couche électroluminescente, une couche de transport de trous, et une couche d'injection de trous ; l'une et/ou l'autre de ces couches d'injection ou de transport peuvent être omises.

Il est connu que de telles structures imposent des contraintes sur le choix des matériaux, notamment en fonction de la valeur du travail de sortie (« work function », en langue anglaise) des électrons pour le matériau des électrodes et de la position des niveaux d'énergie HOMO ou LUMO des électrons ou des trous pour les matériaux organiques des couches intercalées entre ces électrodes (respectivement, en langue anglaise, « Highest Occupied Molecular Orbital » et « Lowest Unoccupied Molecular Orbital »). L'expression « fonction de travail », parfois utilisée, équivaut à celle de « travail de sortie ».

Afin d'éviter ou de limiter de telles contraintes, le document WO02/41414 enseigne d'utiliser des couches organiques dopées entre la couche électroluminescente et les électrodes ; le dopage de telles couches est adapté pour que les charges (trous ou électrons) passent de l'électrode à cette couche dopée par effet tunnel ; l'utilisation de telles couches dopées permet de s'affranchir de la valeur de la fonction de travail de l'électrode ; on peut alors par exemple utiliser de l'ITO (Indium Tin Oxide en langue anglaise) comme cathode.

Le document WO03/083958 propose d'intercaler des couches organiques de blocage (des trous ou des électrons) entre l'une et/ou l'autre de ces couches organiques dopées et la couche électroluminescente. L'adjonction de couches de blocage permet de mieux confiner les porteurs dans la couche électroluminescente elle-même, de limiter les recombinaisons électrons-trous non radiatives, et d'augmenter ainsi le rendement lumineux.

Le document US6639357 décrit également une telle structure comprenant une couche organique conductrice dopée n du côté de la cathode qui sert également de couche de blocage des trous.

Les documents EP0498979, EP1017118, US6013384, US643335 et « Low voltage inverted transparent vacuum deposited organic light - emitting diodes using electrical doping », Applied Physics Letters, vol. 81, no 5, pages 922-924 décrivent également des structures comprenant des couches organiques dopées.

Dans la fabrication des diodes électroluminescentes, se posent des problèmes de planéité ; on sait en effet que les reliefs résiduels du substrat d'une diode, notamment, dans le cas où ce substrat est une matrice active, et les reliefs de l'électrode inférieure elle-même, générés le plus souvent par la méthode de dépôt, posent des problèmes pour l'obtention d'une couche électroluminescente suffisamment plane et d'épaisseur homogène.

Dans le cas de structures classiques (non inversées) où l'anode est l'électrode inférieure, il est connu d'intercaler entre l'anode et la couche électroluminescente une couche organique conductrice de planéité ; comme matériaux conducteurs pour cette couche permettant de rectifier la planéité du substrat, on peut notamment utiliser des mélanges de PEDOT et de PSS (respectivement poly-3,4-éthylène dioxythiophène et poly-styrène sulfonate), de PANI (polyaniline) et de PSS ou d'autres conducteurs organiques comme des dérivés d'amines aromatiques ; le document US2003-0010959 illustre une telle structure ; le document « High-Resistivity PEDT/PSS for reduced crosstalk in passive matrix OELs », de A. Elschner et F. Jonas, publié à l'occasion de la conférence Asia Display / IDW'01, pp. 1427 à 1430 des compendium de cette conférence, illustre la fonction de planification de cette couche. Selon l'art antérieur, de tels matériaux organiques conducteurs sont toujours utilisés du côté de l'anode, comme couche de transport de trous, généralement en association avec une couche d'injection de trous ; en effet, le travail de sortie des électrons de ces matériaux est réputée trop élevée pour pouvoir les utiliser du côté de la cathode, comme couche d'injection d'électrons.

Le document US 2004/095064 décrit l'utilisation du PEDOT:PSS pour former une couche servant à la fois à l'injection et au transport des trous, du côté de l'électrode servant d'anode (voir notamment fin § 8), c'est-à-dire du côté du substrat. Une couche organique dopée p peut être ajoutée pour le transport des trous entre cette couche de PEDOT:PSS et la couche électroluminescente, par exemple à base de m-MTDATA dopée p avec du F4-TCNQ (voir § 27). Du côté de la cathode, on peut utiliser une couche dopée n pour le transport des électrons, par exemple en BPhen dopé avec du lithium (voir § 29).

L'article intitulé « Opposing influence of hole blocking layer and a doped transport layer on the performance of heterostructure OLEDS », publié en décembre 2003 par M. Ben Khalifa, D. Vaufrey, et J. Tardy dans le journal "Organic Electronics", vol.5, n°4, pp.187-198, décrit également des diodes présentant les structures suivantes :
- p. 193, §3.2, device 3 : substrat / ITO (anode) / PEDOT-PSS (injection de trous) /TPD dopé p avec du F4-TCNQ / Alq3 (couche électroluminescente et d'injection d'électrons) / MgAg (cathode)
- p. 195, §3.4, fin du 1" alinéa : substrat / ITO (anode) / PEDOT-PSS (injection de trous) / TPD dopé p avec du F4-TCNQ / DCM avec Alq / BCP avec tBu-PBD / PBD avec Alq à 5% / Mg Ag (cathode).

Le document EP 1394870 décrit une OLED dans laquelle la cathode est constituée de matériau non métallique. Le polymère conducteur polyaniline (PANI) est proposé comme matériau constituant la cathode. Une solution est donnée pour réduire la barrière d'injection des électrons. Le document JP 2001023775 décrit une OLED à structure inversée dans laquelle la cathode est constituée d'un polymère conducteur afin de former un dispositif flexible.

Le document EP 0 996 176 décrit un dispositif d'affichage OLED dans lequel la diode organique électroluminescente a une structure inversée et une couche servant à aplanir la surface de la cathode est formée avant ou après le dépôt de la cathode. Une modification chimique de la surface de la cathode est également envisagée pour faciliter l'injection des électrons dans le dispositif.

Dans les structures inversées de diodes organiques électroluminescentes où la cathode est l'électrode inférieure, le problème de la planéité des couches inférieures n'est actuellement pas résolu d'une manière simple.

Un but de l'invention est de proposer des structures inversées de diode organique électroluminescente, où la cathode est l'électrode inférieure, qui permettent de résoudre d'une manière simple le problème de planéité mentionné ci-dessus.

A cet effet, l'invention a pour objet une diode électroluminescente organique (OLED) telle que décrite dans la revendication 1.

Le dopage n d'un matériau consiste dans l'insertion dans ce matériau d'atomes ou de molécules qui sont donneurs d'électrons, d'une manière adaptée pour augmenter la conductivité de ce matériau, de préférence d'un facteur supérieur à 100 ; on y parvient d'une manière connue en elle-même par modification chimique du matériau de base de cette couche (greffage de radicaux adaptés, par exemple), ou par incorporation d'autres composés adaptés à des concentrations généralement comprises entre 1 pour 10000 et 1 pour 100.

L'invention s'applique aux cas où le travail de sortie des électrons du matériau organique de la couche conductrice de planéité est supérieur à 3,5 eV. En effet, grâce au recouvrement, selon l'invention, de la couche organique conductrice à travail des sortie élevé, donc réputé pouvoir transporter exclusivement des trous, par une couche organique dopée n du côté de la cathode, ce travail de sortie de valeur élevée n'empêche plus la conduction des électrons. Rien n'empêche donc plus d'utiliser cette couche organique à travail de sortie élevé pour améliorer la planéité du côté de la cathode.

Selon l'invention, une électrode dite inférieure est intercalée entre le substrat et la couche organique conductrice de planéité, ce qui permet de répartir de manière plus homogène le courant électrique sur toute la surface active de la diode. Le matériau de cette électrode inférieure est inorganique, par exemple un métal ou un oxyde conducteur ; cette électrode inférieure présente de préférence une conductivité surfacique supérieure à celle de la couche organique de planéité, de préférence, au moins cent fois supérieure.

De préférence, l'électrode inférieure est réflective, ce qui permet de réfléchir la lumière produite par la couche électroluminescente vers l'électrode supérieure transparente, et d'augmenter ainsi le rendement d'extraction de lumière produite. Le matériau de cette électrode inférieure est métallique. On choisit par exemple l'aluminium, le chrome ou l'argent.

Des électrodes organiques sont par exemple décrites dans les documents EP0727100 et US6586764 (PHILIPS).

On entend par couche organique conductrice une couche dont la conductivité perpendiculaire est supérieure ou égale à 10⁻⁵ S/cm. Le matériau de base de la couche organique dopée est semi-conducteur et présente donc un « gap » de niveau d'énergie entre le dernier niveau occupé (HOMO) et le premier niveau inoccupé (LUMO).

La nature et la concentration du dopant de la couche organique dopée sont adaptés d'une manière connue en elle-même pour obtenir la conductivité électrique nécessaire pour limiter la hauteur de la barrière de potentiel entre l'électrode inférieure et cette couche, de manière à permettre le passage des électrons par effet tunnel à cette interface ; en pratique, il importe de préférence à cet effet de doper le matériau de basse de la couche organique de manière à augmenter sa conductivité intrinsèque initiale de plus d'un facteur 10².

Sans se départir de l'invention, d'autres couches organiques peuvent être intercalées dans la structure de cette diode :
- entre la couche organique dopée et la couche électroluminescente, comme une couche de blocage de porteurs : blocage de trous quand l'électrode inférieure est une cathode.
- entre la couche électroluminescente et l'électrode supérieure, comme une couche d'injection et, optionnellement, une couche de transport de porteurs (de trous quand l'électrode supérieure est une anode), une couche de blocage de porteurs (d'électrons quand l'électrode supérieure est une anode), ou, à la place de ces couches d'injection et de transport, une deuxième couche organique dopée (dopée p quand l'électrode supérieure est une anode).

L'épaisseur moyenne de la couche organique conductrice de planéité est supérieure ou égale à 50 nm. Grâce à l'épaisseur relativement importante de cette couche et surtout à la possibilité de l'appliquer à l'état liquide, on parvient à rectifier les défauts de planéité du substrat doté de l'électrode inférieure.

De préférence, le matériau organique de la couche conductrice de planéité comprend au moins un polymère choisi dans le groupe formé par les polythiophènes, les polypyrroles, les polyamines, les polyanilines (PANI), et les polyacétylènes, ainsi que leurs mélanges. Ce polymère peut être mélangé à d'autres polymères ne faisant pas partie de ce groupe.

De préférence, le matériau organique de la couche conductrice de planéité est alors choisi dans le groupe formé par les mélanges de PEDT (polyéthylène dioxythiophène) et de PSS (poly-styrènesulfonate), plus spécialement les mélanges de PEDOT (poly-3,4-éthylène dioxythiophène) et de PSS (poly-styrènesulfonate), les mélanges de PANI (polyaniline) et de PSS (polystyrènesulfonate), et le TTA-DNPB (bis(N,N'-1-naphthyl-phényl-aininobiphényl)-trityl aniline).

Enfin, l'invention a également pour objet un afficheur à diodes électroluminescentes organiques (OLED), caractérisé en ce qu'il comporte un ensemble de diodes (OLED) selon l'invention. Un tel afficheur est avantageusement utilisé pour la visualisation d'images.

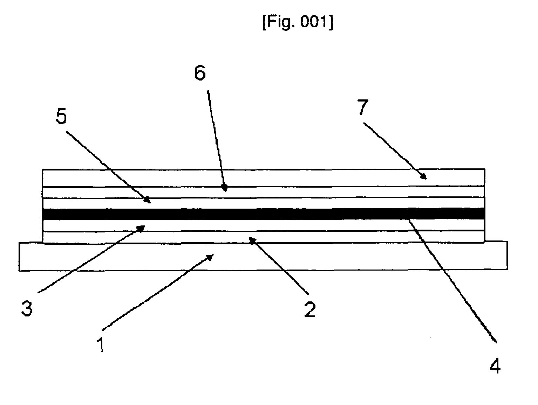

L'invention sera mieux comprise à la lecture de la description qui va suivre, donnée à titre d'exemple non limitatif, et en référence à la figure 1 annexée qui décrit schématiquement une diode organique selon un mode de réalisation de l'invention.

On va maintenant décrire un procédé de réalisation d'un afficheur comprenant un réseau de diodes électroluminescentes selon l'invention qui présentent une structure inversée, c'est à dire où l'électrode arrière ou inférieure de chaque diode est une cathode.

On part d'un substrat 1, généralement une plaque de verre recouverte d'une couche de silicium, dans laquelle ont été gravés des électrodes et les circuits d'une matrice active ; au niveau de l'implantation de chaque diode du panneau, émerge donc de cette couche une électrode, ici une cathode, pour alimenter cette diode. Chaque cathode est reliée en série à un modulateur de courant gravé dans la couche de silicium. Ce modulateur permet de commander la diode déposée sur cette cathode. Les modulateurs sont eux-mêmes commandés par des circuits de pixels pilotables par des réseaux d'électrodes (électrodes de balayage et électrodes de données) qui sont gravés dans ou sous la couche de silicium.

Les cathodes, qui forment la couche 2 d'électrodes inférieures, sont généralement métalliques et de préférence réflectives ; on choisit n'importe quel métal réflecteur, comme par exemple Al, Cr ou Ag.

Pour protéger ce métal de l'oxydation durant l'étape ultérieure de dépôt ultérieur de la couche organique électro-conductrice de planéité, on peut le recouvrir préalablement d'une couche conductrice de protection, par exemple en ITO (Indium Tin Oxide) ou un autre oxyde conducteur. De préférence, cette couche de protection est traitée à l'aide d'un plasma d'oxygène pour améliorer ses propriétés « mouillantes » et ses propriétés électroniques.

Par une méthode d'application à l'état liquide, on dépose ensuite une couche organique conductrice 3 d'un mélange de PEDOT et de PSS; l'avantage bien connu des mélanges de PEDOT et de PSS est qu'il sont applicables en solution, ce qui rend l'application beaucoup plus facile et favorise l'obtention de l'effet de planarisation recherché ; après application, on évapore le solvant ; on obtient ainsi la couche organique conductrice de la diode selon l'invention. La composition et l'épaisseur de cette couche sont adaptées d'une manière connue en elle-même pour obtenir une conductivité électrique transversale (ou perpendiculaire au plan de cette couche) su périeure ou égale à 10⁻³ S/cm.

L'épaisseur des cathodes, y compris le cas échéant la couche intermédiaire conductrice de protection, est adaptée d'une manière connue en elle-même pour que la conductivité surfacique de ces cathodes soit supérieure, de préférence d'au moins 100 fois, à celle de la couche organique conductrice 3. L'épaisseur moyenne de cette couche 3 est comprise entre 5 et 400 nm, de préférence supérieure ou égale à 50 nm, notamment pour obtenir un bon effet d'amélioration de la planéité.

Pour assurer l'injection puis le transport des électrons jusqu'à la couche électroluminescente alors que la couche conductrice organique 3 en PEDOT-PSS qui vient d'être déposée est réputée plutôt adaptée au transport des trous, on applique ensuite une couche organique 4 qui est dopée n, telle que décrite par exemple dans les documents précédemment cités WO02/41414 et WO03/083958. De la sorte, la relation entre le travail de sortie de l'ensemble sous-jacent cathode - couche PEDOT-PSS et les niveaux d'énergie du matériau organique 4 dopée nn'a plus une incidence aussi importante sur les propriétés d'injection de charge, et la couche de PEDOT-PSS devient performante pour l'injection d'électrons dans la couche électroluminescente (déposée ultérieurement). En l'absence de cette couche organique dopée, on aurait une barrière importante pour le transfert des électrons de la couche de PEDOT-PSS vers la couche électroluminescente et on aboutirait à une diode présentant un mauvais rendement.

De nombreux matériaux organiques dopés n peuvent être utilisés pour cette couche organique 4, par exemple du Bphen ou de l'Alq3 dopé avec un métal alcalin comme Li ou Cs, ou dopé avec une molécule ou un radical organique donneur d'électrons dont, de préférence, le niveau HOMO (ou donneur) est voisin (± 0,5 eV) du niveau LUMO (ou accepteur) dudit matériau.

On poursuit la fabrication du panneau d'une manière connue en elle-même, par :
- l'application d'une couche organique électroluminescente 5,
- le dépôt d'une couche organique 6 dopée p adaptée à l'injection et au transport des trous,
- le dépôt d'une anode 7, ici commune à toutes les diodes du panneau ;
- le dépôt d'une couche d'encapsulation transparente, non représentée, pour protéger les diodes contre la détérioration par l'oxygène ou l'humidité.

Les matériaux et l'épaisseur de ces couches sont connus en eux-mêmes, ainsi que les méthodes de dépôts ; ils ne sont donc pas décrits en détail.

On obtient un panneau d'affichage d'images formés d'un réseau de diodes selon l'invention. Les diodes de ce panneau présentent des caractéristiques homogènes et un bon rendement, grâce, notamment, à la couche d'amélioration de planéité 3 qui sert également à l'injection des électrons.

Selon une variante, on interpose une couche de blocage de trous entre la couche organique 4 dopée n et la couche électroluminescente 5.

Selon une autre variante, on interpose une couche de blocage d'électrons entre la couche électroluminescente 5 et la couche organique 6 dopée p.

Selon une autre variante, on remplace la couche organique 6 dopée p par une couche organique d'injection de trous et une couche de transport de trous.

## Revendications

1. Diode électroluminescente organique (OLED) comprenant, sur un substrat (1), une électrode dite inférieure (2), surmontée d'une couche conductrice (3), elle-même surmontée d'une couche organique dopée n (4), elle-même surmontée d'une couche électroluminescente organique (5), elle-même surmontée d'au moins une électrode dite supérieure (7) qui est sensiblement transparente pour la lumière produite dans la couche électroluminescente (5), ladite couche conductrice (3) servant à l'injection d'électrons dans ladite couche électroluminescente (5), **caractérisée en ce que** :
- ladite couche conductrice (3) est organique, est constituée d'un matériau applicable à l'état liquide dont le travail de sortie des électrons est supérieur à 3,5 eV, et présente une épaisseur moyenne supérieure ou égale à 50 nm afin de rectifier les défauts de planéité dudit substrat (1) ;
- ladite électrode inférieure (2) comprend une première couche métallique et une seconde couche conductrice de protection déposée sur la dite première couche métallique et formée d'un matériau inorganique adapté pour protéger contre l'oxydation le métal de ladite première couche métallique.

2. Diode selon la revendication 1 **caractérisée en ce que** le matériau formant ladite seconde couche conductrice de protection est de l'oxyde mixte d'Indium et d'étain (ITO) ou n'importe quel oxyde conducteur.

3. Diode selon l'une quelconque des revendications précédentes **caractérisée en ce que** ladite électrode inférieure (2) présente une conductivité surfacique supérieure à celle de la couche organique conductrice de planéité (3).

4. Diode selon l'une quelconque des revendications précédentes **caractérisée en ce que** l'électrode inférieure est réflective.

5. Diode selon l'une quelconque des revendications précédentes **caractérisée en ce que** le matériau organique de ladite couche conductrice de planéité comprend au moins un polymère choisi dans le groupe formé par les polythiophènes, les polypyrroles, les polyamines, les polyanilines (PANI), et les polyacétylènes, ainsi que leurs mélanges.

6. Diode selon la revendication 5 **caractérisée en ce que** le matériau organique de ladite couche conductrice de planéité est choisi dans le groupe formé par les mélanges de PEDT (polyéthylène dioxythiophène) et de PSS (polystyrènesulfonate), plus spécialement les mélanges de PEDOT (poly-3,4-éthylène dioxythiophène) et de PSS (poly-styrènesulfonate), les mélanges de PANI (polyaniline) et de PSS (polystyrènesulfonate), et le TTA-DNPB (bis(N,N'-I-naphthyl-phényl-aininobiphényl)-trityl aniline).

7. Afficheur à diodes électroluminescentes organiques (OLED), **caractérisé en ce qu'**il comporte un ensemble de diodes selon l'une quelconque des revendications précédentes.

## Claims

1. An organic light-emitting diode (OLED) comprising, on a substrate (1), an electrode called the lower electrode (2), surmounted by a conducting layer (3), itself surmounted by a n-doped organic layer (4), which is itself surmounted by an organic electroluminescent layer (5), which is itself surmounted by at least one electrode called the upper electrode (7) which is substantially transparent to the light produced in the electroluminescent layer (5), said conducting layer (3) serving for injecting electrons into said electroluminescent layer (5), **characterized in that** :
- said conducting layer (3) is organic, is made of a material applicable in liquid state, the electron work function of which is greater than 3.5 eV, has a mean thickness superior or equal to 50 nm in order to rectify planarity defects of said substrate (1);
- said lower electrode (2) comprises a first metallic layer and a second protection conductive layer deposited on said first metallic layer and formed of an inorganic material adapted to protect metal of said first metallic layer against oxidation.

2. The diode as claimed in claim 1, **characterized in that** the material forming said second protection conductive layer is Indium Tin Oxide (ITO) or any conducting oxide.

3. The diode as claimed in any one of the preceding claims, **characterized in that** said lower electrode (2) has a surface conductivity greater than that of the conducting organic planarizing layer (3).

4. The diode as claimed in any one of the preceding claims, **characterized in that** the lower electrode is reflective.

5. The diode as claimed in any one of the preceding claims, **characterized in that** the organic material of said conducting planarizing layer comprises at least one polymer chosen from the group formed by polythiophenes, polypyrrols, polyamines, polyanilines (PANI) and polyacetylenes, and also blends thereof.

6. The diode as claimed in claim 5, **characterized in that** the organic material of said conducting planarizing layer is chosen from the group formed by PEDT (polyethylene dioxythiophene)/PSS (polystyrenesulfonate) blends, more especially PEDOT (poly-3,4-ethylene dioxythiophene)/PSS (polystyrenesulfonate) blends, PANI (polyaniline)/PSS (polystyrenesulfonate) blends and TTA-DNPB (bis(N,N'-I-naphthylphenylaminobiphenyl)trityl aniline).

7. An organic light-emitting diode (OLED) display, **characterized in that** it comprises a set of diodes as claimed in any one of the preceding claims.

## Patentansprüche

1. Organische elektrolumineszierende Diode (OLED), welche auf einem Substrat (1) Folgendes aufweist: eine so genannte untere Elektrode (2), auf die eine leitende Schicht (3) aufgesetzt ist, auf die wiederum eine n-dotierte organische Schicht (4) aufgesetzt ist, auf die wiederum eine organische elektrolumineszierende Schicht (5) aufgesetzt ist, auf die wiederum mindestens eine so genannte obere Elektrode (7) aufgesetzt ist, die für das in der elektrolumineszierenden Schicht (5) erzeugte Licht im Wesentlichen transparent ist, wobei die leitende Schicht (3) für das Einspeisen von Elektronen in die elektrolumineszierende Schicht (5) dient, **dadurch gekennzeichnet, dass**
- die leitende Schicht (3) organisch ist, aus einem Material besteht, das in flüssigem Zustand aufgetragen werden kann und bei dem die Elektronen-Ausgangsarbeit größer als 3,5 eV ist, und eine mittlere Dicke aufweist, die größer oder gleich 50 nm ist, um die Unebenheiten des Substrats (1) zu korrigieren,
- die untere Elektrode (2) eine erste metallische Schicht und eine zweite leitende Schutzschicht umfasst, die auf die erste metallische Schicht gesetzt ist und aus einem anorganischen Material besteht, das geeignet ist, das Metall der ersten metallischen Schicht gegen Oxidation zu schützen.

2. Diode nach Anspruch 1, **dadurch gekennzeichnet, dass** das die zweite leitende Schutzschicht bildende Material ein Indium-Zinn-Mischoxid (ITO) oder ein beliebiges leitendes Oxid ist.

3. Diode nach einem beliebigen der vorhergehenden Ansprüche, **dadurch gekennzeichnet, dass** die untere Elektrode (2) eine Oberflächenleitfähigkeit aufweist, die größer ist als diejenige der organischen leitenden Ebenheitsschicht (3).

4. Diode nach einem beliebigen der vorhergehenden Ansprüche, **dadurch gekennzeichnet, dass** die untere Elektrode reflektierend ist.

5. Diode nach einem beliebigen der vorhergehenden Ansprüche, **dadurch gekennzeichnet, dass** das organische Material der leitenden Ebenheitsschicht mindestens ein Polymer umfasst, das aus der Gruppe gewählt ist, die durch die Polythiophene, Polypyrrole, Polyamine, Polyaniline (PANI) und Polyacetylene sowie deren Gemische gebildet ist.

6. Diode nach Anspruch 5, **dadurch gekennzeichnet, dass** das organische Material der leitenden Ebenheitsschicht aus der Gruppe gewählt ist, die durch die Gemische aus PEDT (Polyethylendioxythiophen) und PSS (Polystyrensulfonat), insbesondere durch die Gemische aus PEDOT (Poly-3,4-ethylendioxythiophen) und PSS (Polystyrensulfonat), die Gemische aus PANI (Polyanilin) und PSS (Polystyrensulfonat), und TTA-DNPB (bis(N, N'-I-naphthylphenylaminobiphenyl)trityl aniline) gebildet ist.

7. Display mit organischen elektrolumineszierenden Dioden (OLED), **dadurch gekennzeichnet, dass** sie eine Anordnung von Dioden nach einem beliebigen der vorhergehenden Ansprüche aufweist.
